Europäisches Patentamt

European Patent Office

Office européen des brevets

(19)

(11) Publication number: **0 029 735**
**B1**

# EUROPEAN PATENT SPECIFICATION

(12)

(45) Date of publication of patent specification: **11.04.84**

(21) Application number: **80304217.5**

(22) Date of filing: **25.11.80**

(51) Int. Cl.³: **H 03 K 3/354,**
**G 11 C 17/00**

(54) An oscillator circuit and an EPROM including such a circuit.

(30) Priority: **27.11.79 JP 153109/79**

(43) Date of publication of application:
**03.06.81 Bulletin 81/22**

(45) Publication of the grant of the patent:
**11.04.84 Bulletin 84/15**

(84) Designated Contracting States:
**DE FR GB NL**

(56) References cited:
**EP - A - 0 011 975**
**DE - A - 2 920 966**
**US - A - 3 599 116**
**US - A - 3 938 108**

(73) Proprietor: **FUJITSU LIMITED**
**1015, Kamikodanaka Nakahara-ku**
**Kawasaki-shi Kanagawa 211 (JP)**

(72) Inventor: **Higuchi, Mitsuo**
**5-13, Yutenji 2-chome Meguro-ku**
**Tokyo 153 (JP)**

(74) Representative: **Rackham, Stephen Neil et al,**
**GILL JENNINGS & EVERY 53-64 Chancery Lane**
**London WC2A 1HN (GB)**

An oscillator circuit and an EPROM including such a circuit

This invention relates to an oscillator circuit that is particularly intended for controlling a bootstrap circuit included in an EPROM (Erasable Programmable Read Only Memory) which is erasable by means of ultraviolet radiation.

In general, a package containing an EPROM which is erasable by means of ultraviolet radiation includes a window to admit ultraviolet radiation. During erasure of the contents stored in the memory of the EPROM, ultraviolet radiation is admitted through the window. However, during writing of data into the EPROM, light may also penetrate through the window and impinge on the EPROM. Light incident upon junction capacitances in a bootstrap circuit included in the EPROM tends to increase the leakage of charge from the junction capacitances, with the result that the write-in voltage is lowered to such an extent that data is not written in. In order to avoid this lowering of the voltage, an oscillator circuit is usually included in the EPROM so that the junction capacitances are repeatedly charged up during writing in of data.

However, with a conventional oscillator circuit, the oscillating frequency is constant regardless of the intensity of the incident light with the result that the frequency is too high or too low when the incident light rays are relatively feeble or relatively intense, respectively. More precisely, the high potential H and the low potential L are alternately repeated at the output of the oscillator circuit. Each of the high potential levels corresponds to a writing interval. Each of the low potential corresponds to a reset interval for charging up the junction capacitances. If the frequency is too high, the sum of the reset intervals becomes too large, so that the writing time is reduced to such an extent that data cannot be written in the EPROM sufficiently quickly. On the contrary, if the frequency is too low, charges leak away from the junction capacitances, as a result of the incident light as mentioned above so that the charging up of the junction capacitances during each reset interval is not sufficient to obtain a voltage high enough to enable data to be written into the EPROM. In both cases the write-in efficiency is unacceptable.

US—A—3 599 116 describes an oscillator circuit for providing an oscillating signal, the frequency of which varies in response to the intensity of incident radiation, the oscillator circuit comprising a capacitance means for storing charge, the leakage of charge from the capacitance means being dependent upon the intensity of radiation incident upon the capacitance means, and a first waveform shaping circuit for converting a change in voltage across the capacitance means to a rectangular waveform.

According to this invention such an oscillator circuit also comprises a delay circuit for delaying the waveform output by the first waveform shaping circuit for a predetermined time, a second waveform shaping circuit for converting the change of voltage output by the delay circuit to a rectangular waveform with steep leading and trailing edges, and a charging circuit connected to the output of the second waveform shaping circuit for charging the capacitance means.

A particular example of an EPROM and an oscillator circuit in accordance with this invention will now be described with reference to the accompanying drawings; in which:—

Figure 1 is a circuit diagram of an oscillator circuit;

Figure 2 is a circuit diagram of part of a write-in circuit of an EPROM which is connected to the output of the circuit shown in Figure 1.

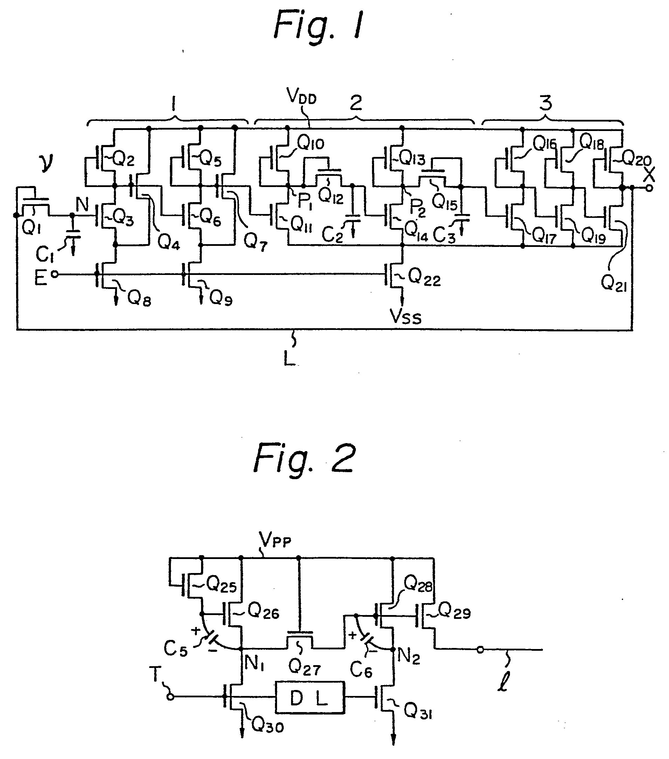

Now, referring to Fig. 1, an oscillation circuit according to an embodiment of the present invention is illustrated. In Fig. 1, $Q_1$ represents an MOS transistor for controlling the oscillation frequency; and $C_1$ represents a junction capacitance of the source of the MOS transistor $Q_1$. When external light rays $v$ are incident on the junction capacitance $C_1$ through a window which is provided, for radiating ultraviolet rays therethrough, on a package of an EPROM, the charges stored in the junction capacitance $C_1$ will leak out, causing the voltage across the junction capacitance $C_1$ to sag. The voltage across the junction capacitance $C_1$ is detected by a wave-form shaping circuit 1 provided in the input stage of the oscillation circuit. A delay circuit 2 for determining a reset interval of the oscillation circuit is connected to the wave-form shaping circuit 1. As an output stage of the oscillating circuit, another waveform shaping circuit 3 is connected to the delay circuit.

The wave-form shaping circuit 1 of the input stage is comprised of MOS transistors $Q_2$ through $Q_9$. The transistors $Q_2$, $Q_3$ and $Q_8$ are connected in series between a power supply voltage $V_{DD}$ and the ground voltage $V_{SS}$. Also, the transistors $Q_5$, $Q_6$ and $Q_9$ are connected in series between the power supply voltage $V_{DD}$ and the ground voltage $V_{SS}$. The gate and the source of the transistor $Q_2$ are commonly connected to the gate of the gate of the transistor $Q_4$ which is connected between the power supply voltage $V_{DD}$ and the source of the transistor $Q_3$. Also, the gate and the source of the transistor $Q_5$ are commonly connected to the gate of the transistor $Q_7$ which is connected between the power supply voltage $V_{DD}$ and the source of the transistor $Q_6$. A set of the transistors $Q_2$ and $Q_3$ constitutes a first inverter circuit. Also, a set of the transistors $Q_5$ and $Q_6$ con-

situtes a second inverter. The gate and the source of the transistor $Q_2$ are commonly connected to the gate of the transistor $Q_4$. Also, the gate and the source of the transistor $Q_5$ are commonly connected to the gate of the transistor $Q_7$. Each of the transistors $Q_4$ and $Q_7$ acts as a positive feedback element. The gates of the transistors $Q_8$ and $Q_9$ are connected to an enabling terminal E. When an oscillation enabling signal is applied to the terminal E to turn on these transistors $Q_8$ and $Q_9$ during programming of the EPROM, this wave-form shaping circuit 1 is turned to its operating state. In the operating state of the wave-form shaping circuit 1, when the input voltage varies gradually, that is, when the voltage at a node N connected to the capacitor $C_1$ varies gradually, a rapid change of a wave form is generated at the output of the wave-form shaping circuit 1 in response to the time when the input voltage reaches a threshold value. Since there are two stages of inverters, the phase of the input signal is the same as that of the output signal. Thus, the wave form of the input signal is shaped by the wave-form shaping circuit 1 so that a rectangular wave is obtained at the output of this wave-form shaping circuit.

The delay circuit 2 is comprised of MOS transistors $Q_{10}$ through $Q_{15}$ and capacitors $C_2$ and $C_3$. The transistors $Q_{10}$ and $Q_{11}$ connected in series constitute a first buffering inverter. Also, the transistors $Q_{13}$ and $Q_{14}$ connected in series constitute a second buffering inverter. The gate of the transistor $Q_{10}$ is connected to the connecting point $P_1$ between the source of the transistor $Q_{10}$ and the drain of the transistor $Q_{11}$. Also, the gate of the transistor $Q_{13}$ is connected to the connecting point $P_2$ between the source of the transistor $Q_{13}$ and the drain of the transistor $Q_{14}$. The transistor $Q_{12}$ is connected between the connecting point $P_1$ and the gate of the transistor $Q_{14}$. Also, the transistor $Q_{15}$ is connected between the connecting point $P_2$ and the gate of a transistor $Q_{17}$ which is included in the wave-form shaping circuit 3. The transistor $Q_{12}$ and the capacitor $C_2$ connected to the source of the transistor $Q_{12}$ constitute a CR time constant circuit. Also, the transistor $Q_{15}$ and the capacitor $C_3$ connected to the source of the transistor $Q_{15}$ constitute another CR time constant circuit. The gate of the transistor $Q_{11}$ is connected to the gate of the transistor $Q_7$.

The wave-form shaping circuit 3 is comprised of MOS transistors $Q_{16}$ through $Q_{21}$. Three pairs of the transistors $Q_{16}$ and $Q_{17}$, $Q_{18}$ and $Q_{19}$ and $Q_{20}$ and $Q_{21}$ constitute three stages of inverters. When the input voltage at the gate of the transistor $Q_{17}$ varies gradually, this gradual variation being caused by the delay circuit 2, a rapid change of wave form is generated at the output X of the wave-form shaping circuit 3 in response to the time when the input voltage reaches a threshold value.

The sources of the transistors $Q_{11}$, $Q_{14}$, $Q_{17}$, $Q_{19}$ and $Q_{21}$ are commonly connected to the drain of an MOS transistor $Q_{22}$, the gate of which is connected to the enabling terminal E, and the source of which is connected to the ground voltage $V_{ss}$.

During read out time, the enabling terminal E is turned to a low potential so that the transistors $Q_8$, $Q_9$ and $Q_{22}$ are turned off the cause the circuits 1, 2 and 3 be inoperative.

In the operation of the circuit of Fig. 1, the oscillation enabling signal is applied to the enabling terminal E to turn on the transistors $Q_8$, $Q_9$ and $Q_{22}$, causing the circuits 1, 2 and 3 to be operative. Since, as mentioned above, the wave-form shaping circuit 1 comprises two stages of inverters, including positive feedback transistors, a slowly varying wave form at the input is shaped to a rapidly varying wave form having the same phase as the phase of the input signal. The delay circuit 2 produces at its output a delayed wave form having the same phase as the phase of the input signal. The delayed amount is determined by the two stages of the CR time constant circuits. Since the wave-form shaping circuit 3 includes three stages of inverters, the circuit 3 has the function to invert the phase of its input signal, as well as the function to shape the wave form of its input signal. Therefore, the wave-form shaping circuit 3 shapes and inverts the output signal of the delay circuit 3 to provide an output signal at the terminal X. The output signal at the terminal X has the inverted phase as the input signal at the node N and is delayed by a predetermined time from the input signal. The output signal at the terminal X is fed back through a line L to the drain of the transistor $Q_1$ for oscillation.

The oscillation frequency of this circuit is dependent on the junction capacitance $C_1$. When light rays $v$ are incident on the junction capacitance, charges stored in the capacitance $C_1$ leak out so that the voltage at the node N is lowered to a low potential. When the voltage at the node N reached the threshold voltage of the first stage inverter in the wave-form shaping circuit 1, the first stage inverter inverts its state. Then, after a predetermined time mainly determined by the time constant of the delay circuit 2, the output signal at the output terminal X is turned to a high potential H. This high voltage is applied to the transistor $Q_1$ to turn it on. Thus, the junction capacitance $C_1$ is charged up by the high voltage applied through the transistor $Q_1$. After charging the capacitance $C_1$, the voltage at the node N becomes high H so that the voltage at the output terminal X becomes low L after a predetermined time. In this condition, if no light ray is incident on the junction capacitance $C_1$, charges stored in the capacitance $C_1$ hardly leak out, so that the input voltage at the node N is kept at the high level H, causing the oscillation to stop. However, when light rays $v$ are incident on the junction capacitance $C_1$ again, charges stored in the capacitance $C_1$ are decreased with a speed corresponding to the intensity of the incident light rays, so that the amount of the stored charges becomes smaller than a predetermined value, causing the first stage of the inverters in the wave-form shaping circuit 1 to invert its state, and after a predetermined time of the time constant of the delay circuit 2, the output voltage at the terminal X of the wave-form shaping circuit 3 is turned again to the high level H. Thus, the junction capacitance $C_1$ is again charged by the high voltage H. As far as light rays $v$ are incident on the junction capacitance, the above described oscillation is effected. The oscillation frequency becomes high along with the increase of the intensity of the light rays $v$, and becomes low along with the decrease of the intensity of the light rays $v$. For example, when the period of the oscillation is initially set at 50 through 100 microseconds under the intensity of room light, the period of oscillation may be shortened to about 10 microseconds under relatively intense light rays, and the period of oscillation may be elongated to several ten miliseconds under relatively feeble light rays.

The circuit of Fig. 1 is utilized to control, for example, a bootstrap circuit as illustrated in Fig. 2, which is included in a PROM (Programable Read Only Memory). In Fig. 2, I represents a conduction line, or a bit line, connected to memory cells in the PROM; $V_{PP}$ represents a high power supply voltage of, for example, 25V for writing data in the PROM; $Q_{29}$ represents a transistor for controlling the power supply voltage $V_{PP}$ to connect to or disconnect from the conduction line I, the gate of the transistor $Q_{29}$ being controlled by two stages of the bootstrap circuits; $C_5$ and $C_6$ represent the capacitances of the bootstrap circuits; $Q_{25}$ through $Q_{28}$ represent the transistors of the bootstrap circuit; $Q_{30}$ and $Q_{31}$ represent transistors for controlling the bootstrap circuit; DL represents a delay circuit, and; T represents a control terminal for receiving the oscillation frequency from the output terminal X of the circuit of Fig. 1.

In the operation of the circuit of Fig. 2, when the input voltage at the control terminal T becomes high H, the transistor $Q_{30}$ turns on so that the capacitor $C_5$ is charged by the power supply voltage $V_{PP}$ through the transistor $Q_{25}$ to have a polarity as illustrated. Also, after a time delay determined by the delay circuit DL, the transistor $Q_{31}$ is turned on so that the capacitor $C_6$ is discharged to the ground level through the transistors $Q_{27}$ and $Q_{30}$. The transistor $Q_{29}$ receives at its gate the voltage across the capacitor $C_6$. So, the voltage across the capacitor $C_6$ when the transistors $Q_{30}$ and $Q_{31}$ are on is not sufficient to turn on the transistor $Q_{29}$. Therefore, when the voltage at the control terminal T is high H, the conduction line I is separated from the power supply voltage $V_{PP}$.

When the input voltage at the control terminal T becomes low L, the transistor $Q_{30}$ turns off, so that the potential at the node $N_1$ increases. Since the potential at the gate of the transistor $Q_{26}$ is higher than the potential at the

node $N_1$ by the voltage across the capacitance $C_5$, the transistor $Q_{26}$ is driven to completely turn on. Thus, the potential at the node $N_1$ increases to a voltage nearly equal to the power supply voltage $V_{PP}$ without being decreased by the threshold voltage $V_{TH}$ of the transistor $Q_{26}$. The voltage at the node $N_1$ is applied through the transistor $Q_{27}$ to the capacitance $C_6$ to charge it, as well as to the gate of the transistor $Q_{29}$ to turn it on. Thus, the potential of the conduction line I increases. After the time delay of the delay circuit DL, the gate of the transistor $Q_{31}$ receives the low voltage L so that the transistor $Q_{31}$ turns off. Then, the potential at the node $N_2$ increases. The potential at the gate of the transistor $Q_{28}$ then becomes higher than the potential at the node $N_2$ by the voltage across the capacitance $C_6$, resulting in the further increase of the potential at the node $N_2$ to a value nearly equal to the power supply voltage $V_{PP}$. Also, the potential at the gates of the transistors $Q_{28}$ and $Q_{29}$ becomes higher than the potential at the node $N_2$. Then, the transistor $Q_{27}$ is turned off. Thus, the potential of the conduction line I increases to the power supply voltage $V_{PP}$. This operation, as described with reference to Fig. 2, is well known as a bootstrap operation.

When the potential of the conduction line I is high H, or, in other words, when the potential at the control terminal T which receives control signals from the output terminal X of the circuit of Fig. 1 is low L, data are written in the PROM. That is, when the potential of the conduction line I is high H, each cell in the PROM receives between its source and drain a high voltage to cause an avalanche breakdown in the cell. The avalanche breakdown produces hot electrons or holls which are then injected into the floating gate of the cell.

When data is to be read out from the PROM, the Transistor $Q_{29}$ is turned off so that the conduction line I is disconnected from the power supply voltage $V_{PP}$, because, in the reading operation, the potential of the conduction line I is not required to be as high as the power supply voltage $V_{PP}$.

The capacitances $C_5$ and $C_6$ in the bootstrap circuit of Fig. 2 used for writing data in the PROM also are constructed by junction capacitances or MOS capacitances, and therefore, when external light rays are incident on these capacitances $C_5$ and $C_6$, charges stored in these capacitances $C_5$ and $C_6$ will leak out within a time of, for example, about 1 millisecond, while several ten milliseconds are required to write data in the PROM. Therefore, these capacitances are required to be repeatedly charged to keep the voltage across the capacitance $C_5$ or $C_6$. The frequency of the repetition of the charging preferably corresponds to the intensity of the incident external light. That is, if the frequency is too high, the reset intervals or charging intervals disturb writing as described before, and, if the frequency is too low, the voltage across the capacitor $C_5$ or $C_6$ cannot be maintained.

The delay circuit 2 in the circuit of Fig. 1 determines the reset interval or, in other words, the interval for charging the capacitances $C_5$ and $C_6$ in the bootstrap circuit of Fig. 2 the reset interval being set to, for example, 2 microseconds. In a conventional delay circuit corresponding to the delay circuit of Fig. 1, the gates of the transistors $Q_{12}$ and $Q_{15}$ were connected to a high potential power supply $V_{DD}$. However, by such conventional wiring, since the operations of the delay circuit were the same when the potential at the node N is turned from H to L and from L to H, the delay times were the same in both cases. By the conventional wiring, in order to obtain a large CR time constant, it is necessary to enlarge the channel length of the transistor $Q_{12}$ or $Q_{15}$, or to increase the area of the capacitances $C_2$ and $C_3$. In both cases, the area of the circuit is increased.

According to the embodiment of the present invention, as illustrated in Fig. 1, the transistors $Q_{12}$ and $Q_{15}$ used as resistances in the CR time constant circuits are of a depletion type. Also, the gate is connected to the drain or the source in each of the transistors $Q_{12}$ and $Q_{15}$. By this construction, the equivalent resistance of each of the transistors $Q_{12}$ and $Q_{15}$, when its input voltage varies from L to H, or in other words, when the transistor $Q_{11}$ is going to be turned off, is smaller than that when its input voltage varies from H to L. Therefore, with respect to the CR time constant circuit of the transistor $Q_{12}$ and the capacitance $C_2$, the time constant, during which the capacitance $C_2$ is being charged, that is, when the voltage at the connecting point $P_1$ is being increased from L to H, is smaller than the time constant, durring which the capacitance $C_2$ is being discharged, that is, when the voltage at the connecting point $P_1$ is being decreased from H to L. When the first buffering inverter comprised of the transistors $Q_{10}$ and $Q_{11}$ inverts its input voltage from H to L to L to H, the second buffering inverter comprised of the transistors $Q_{13}$ and $Q_{14}$ inverts its input voltage from L to H or H to L, respectively. Therefore, in contrast to the transistor $Q_{12}$ in the first buffering inverter, the gate of the transistor $Q_{15}$ in the second buffering inverter is connected to the source, that is, to the output of the delay circuit 2, so that the delay times of both CR time constant circuits are added and thus are not canceled by each other. By this construction of the delay circuit 2 of Fig. 1, the delay time, required to transfer the change from L to H at the node N to the output terminal X as the reverse change from H to L, is larger than the delay time required to transfer the change from H to L at the node N to the output terminal X as the reverse change from L to H. In the circuit of Fig. 1, the interval during the output terminal X being H, i.e., the reset interval should be a predetermined interval (for example, 2 microseconds). To this end, it is preferable that the interval between the transition from L to H at the node N and the transition from H to L at the terminal X is much larger. Thus, by using the circuit of Fig. 1, small area circuit can be realized.

The delay circuit 2 is not restricted to the one illustrated in Fig. 1, but may be a conventional delay circuit. When the conventional delay circuit is employed, although the area of the circuit is increased, the write-in efficiency is also improved by the fact that, according to the present invention, the oscillation frequency is changed in response to the intensity of incident light rays $v$.

Although the second wave-form shaping circuit 3 has three stages of inverters in the foregoing embodiment, the number of stages is not restricted to three, but may be any number as long as the phase of the signal at the output of the oscillation circuit is inverted from the phase of the input signal at the input of the first wave-form shaping circuit, when the bootstrap circuit is such that, as illustrated in Fig. 2, the high potential of the conduction line I corresponds to the low potential at its input T. If the bootstrap circuit is such that the high potential of a conduction line corresponds to the high potential at its input, the phase at the output of the oscillation circuit must, of course, be the same as the phase at the input of the first wave-form shaping circuit.

From the foregoing description, since the oscillation frequency of the oscillation circuit according to the present invention can be changed to set its optimum value in response to the intensity of incident light rays, it will be apparent that the write-in efficiency is greatly improved when the oscillation circuit is adapted to, for example, a bootstrap circuit in an PROM of a type erasable by means of ultraviolet rays.

**Claims**

1. An oscillator circuit (1, 2, 3) for providing an oscillating signal the frequency of which varies in response to the intensity of incident radiation ($v$) comprising a capacitance means (C1) for storing charge, the leakage of charge from the capacitance means (C1) being dependent upon the intensity of radiation ($v$) incident upon the capacitance means (C1), a first waveform shaping circuit (1) for converting a change in voltage across the capacitance means (C1) to a rectangular waveform characterised in that it also comprises a delay circuit (2) for delaying the waveform output by the first waveform shaping circuit (1) for a predetermined time, a second waveform shaping circuit (3) for converting the change of voltage output by the delay circuit (2) to a rectangular waveform with steep leading and trailing edges, and a charging circuit (L, Q1) connected to the output of the second waveform shaping circuit (3) for charging the capacitance means (C1).

2. An oscillator circuit (1, 2, 3) according to claim 1, wherein the second waveform shaping circuit (3) includes means for inverting the phase of its input signal.

3. An oscillator circuit (1, 2, 3) according to claim 1 or 2, wherein the incident radiation ($v$) is that incident through a window for erasing ultraviolet radiation in an EPROM of a type which is erasable by ultraviolet radiation.

4. An oscillator circuit (1, 2, 3) according to claim 3, wherein the output of the oscillator circuit (1, 2, 3) is connected to an input of a controlling circuit for recharging capacitances (C5, C6) included in a bootstrap circuit of the EPROM.

5. An oscillator circuit (1, 2, 3) according to any one of the preceding claims, wherein the charging circuit is a MOS transistor (Q1) the gate and the drain of which are connected to the output of the oscillator circuit, and the source of which is connected to the input of the first waveform shaping circuit (1).

6. An oscillator circuit (1, 2, 3) according to claim 5, wherein the capacitance means (C) is the junction capacitance of the MOS transistor (Q1).

## Revendications

1. Un circuit oscillateur (1, 2, 3) destiné à produire un signal d'oscillation dont la fréquence varie en fonction de l'intensité d'un rayonnement incident ($v$), comprenant des moyens capacitifs (C1) destinés à emmagasiner une charge, la fuite de la charge à partir des moyens capacitifs (C1) dépendant de l'intensité du rayonnement ($v$) qui tombe sur les moyens capacitifs (C1), et un premier circuit de mise en forme de signal (1) destiné à convertir un changement de tension aux bornes des moyens capacitifs (C1) en un signal rectangulaire, caractérisé en ce qu'il comprend également un circuit de retard (2) destiné à retarder d'une durée prédéterminée le signal de sortie du premier circuit de mise en forme de signal (1), un second circuit de mise en forme de signal (3) destiné à convertir le changement de la tension émise par le circuit de retard (2) en un signal rectangulaire avec des fronts avant et arrière raides, et un circuit de charge (L, Q1) connecté à la sortie du second circuit de mise en forme de signal (3) pour charger les moyens capacitifs (C1).

2. Un circuit oscillateur (1, 2, 3) selon la revendication 1, dans lequel le second circuit de mise en forme de signal (3) comprend des moyens destinés à inverser la phase de son signal d'entrée.

3. Un circuit oscillateur (1, 2, 3) selon la revendication 1 ou 2, dans lequel le rayonnement incident ($v$) est le rayonnement qui traverse une fenêtre destinée à un rayonnement ultraviolet d'effacement dans une mémoire EPROM d'un type effaçable par un rayonnement ultraviolet.

4. Un circuit oscillateur (1, 2, 3) selon la revendication 3, dans lequel la sortie du circuit oscillateur (1, 2, 3) est connectée à une entrée d'un circuit de commande destiné à recharger des capacités (C5, C6) incorporées dans un circuit "bootstrap" de la mémoire EPROM.

5. Un circuit oscillateur (1, 2, 3) selon l'une quelconque des revendications précédentes, dans lequel le circuit de charge est un transistor MOS (Q1) dont la grille et le drain sont connectés à la sortie du circuit oscillateur, et dont la source est connectée à l'entrée du premier circuit de mise en forme de signal (1).

6. Un circuit oscillateur (1, 2, 3) selon la revendication 5, dans lequel les moyens capacitifs (C1) sont cobstitués par la capacité de jonction du transistor MOS (Q1).

## Patentansprüche

1. Oszillatorschaltung (1, 2, 3) zur Lieferung eines oszillierenden Signals dessen Frequenz in Abhängigkeit von der Intensität der einfallenden Strahlung ($v$) variiert, mit einer Kondensatoreinrichtung (C1) zur Ladungsspeicherung, wobei der Ladungsverlust der Kondensatoreinrichtung (C1) von der Intensität der auf sie einfallenden Strahlung ($v$) abhängt, einer ersten Wellenformerschaltung (1) zur Umwandlung einer Änderung der Spannung an der Kondensatoreinrichtung (C1) in eine rechteckige Wellenform, gekennzeichnet durch eine Verzögerungsschaltung (2) zur Verzögerung des Wellenformausgangs der ersten Wellenformerschaltung (1) um eine vorbestimmte Zeit, eine zweite Wellenformerschaltung (3) zur Umwandlung der Änderung der von der Verzögerungsschaltung (2) abgegebenen Spannung in eine rechteckige Wellenform mit steilen Vorder- und Rückflanken, und eine Ladeschaltung (L, Q1), welche zur Aufladung der Kondensatoreinrichtung (C1) mit dem Ausgang der zweiten Wellenformerschaltung (3) verbunden ist.

2. Oszillatorschaltung (1, 2, 3) nach Anspruch 1, bei welcher die zweite Wellenformerschaltung. (3) eine Einrichtung zur Invertierung der Phase ihres Eingangssignals umfaßt.

3. Oszillatorschaltung (1, 2, 3) nach Anspruch 1 oder 2, bei welcher die einfallende Strahlung ($v$) diejenige ist, welche durch eine Fenster für ultraviolette Strahlung in einem EPROM eines Typs einfällt, welcher durch ultraviolette Strahlung löschbar ist.

4. Oszillatorschaltung (1, 2, 3) nach Anspruch 3, bei welcher der Ausgang der Oszillatorschaltung (1, 2, 3) mit einem Eingang einer Steuerschaltung zur Wiederaufladung der Kondensatoren (C5, C6) verbunden ist, welche in einer Bootstrapschaltung des EPROM enthalten sind.

5. Oszillatorschaltung (1, 2, 3) nach einem der vorhergehenden Ansprüche, bei welcher die Ladeschaltung ein MOS-Transistor (Q1) ist, dessen Gate und Drain mit dem Ausgang der Oszillatorschaltung verbunden sind und dessen Source mit dem Eingang der ersten Wellenformerschaltung (1) verbunden ist.

6. Oszillatorschaltung (1, 2, 3) nach Anspruch 5, bei welcher die Kondensatoreinrichtung (C) die Grenzschichtkapazität des MOS-Transistors (Q1) ist.

7

# Fig. 1

# Fig. 2